# EUROPEAN PATENT SPECIFICATION

(11) **EP 2 525 360 B1**
(45) Date of publication and mention of the grant of the patent: **10.03.2021**
(21) Application number: 12168232.2
(22) Date of filing: 16.05.2012
(51) Int. Cl.: G11C 11/56, G11C 27/00, G11C 16/34

(54) **Sparse programming of analog memory cells**
Verstreute Programmierung analoger Speicherzellen
Programmation rare de cellules de mémoire analogiques

(30) Priority: 16.05.2011 US 201161486330 P; 28.12.2011 US 201113338335
(43) Date of publication of application: 21.11.2012
(73) Proprietor: Apple Inc., Cupertino CA 95014 (US)
(72) Inventor: Gurgi, Eyal, Petah-Tikva (IL)
(74) Representative: Pagenberg, Jochen

(56) References cited:
- EP-A1- 1 892 720

## Description

### CROSS-REFERENCE TO RELATED APPLICATIONS

This application claims the benefit of U.S. Provisional Patent Application 61/486,330, filed May 16, 2011 .

### FIELD OF THE INVENTION

The present invention relates generally to memory devices, and particularly to methods and systems for data storage in analog memory cells.

### BACKGROUND OF THE INVENTION

Some memory devices, such as Flash devices, comprise arrays of analog memory cells. In some cases, neighboring memory cells in the array may cause cross-coupling interference to one another. Various techniques for reducing interference in memory devices are known in the art. Example techniques are described in U.S. Patent Application Publications 2008/0198650, 2009/0024905, 2009/0158126, 2010/0131 826.

Some memory systems employ means for protecting critical information. For example, U.S. Patent Application Publication 2009/0193184, describes a hybrid Solid-State Disk (SSD) having Multi-Level-Cell (MLC) or Single-Level-Cell (SLC) Flash memory, or both. SLC Flash may be emulated by MLC that uses fewer cell states. Data reliability is improved since fewer MLC states are used, and noise margins may be relaxed.

EP 1 892 720 A1 discloses a solid-state mass storage device defining a storage area adapted to store data; the storage area is adapted to be exploited for storing data with a first storage density at a first data transfer speed. The storage area comprises at least a first storage area portion and a second storage area portion. The solid-state mass storage device further includes accessing means adapted to exploit the first storage area portion for storing data with a second storage density at a second data transfer speed, and adapted to exploit the second storage area portion for storing data with a third storage density and a third data transfer speed. The second storage density is lower than the third storage density, which is in turn lower than or equal to the first storage density; the second data transfer speed is higher than the third data transfer speed, which is in turn higher than or equal to the first data transfer speed

### SUMMARY OF THE INVENTION

The present invention is defined in the appended independent claims to which reference should be made. Advantageous features are set out in the appended dependent claims.

An embodiment of the present invention that is described herein provides a method for data storage in a memory that includes an array of analog memory cells. A group of the memory cells is selected such that each memory cell in the group has one or more neighbor memory cells in the array that are excluded from the group. Data is stored in the group of the memory cells while excluding the neighbor memory cells from programming as long as the data is stored in the group of the memory cells.

In some embodiments, selecting the group includes excluding from the group all the immediate neighbor memory cells of each memory cell in the group. Selecting the group may include, for at least a part of the array, excluding from the group all the memory cells belonging to odd-order word lines or all the memory cells belonging to even-order word lines. In another embodiment, selecting the group includes, for at least a part of the array, excluding from the group all the memory cells belonging to odd-order bit lines or all the memory cells belonging to even-order bit lines.

In a disclosed embodiment, selecting the group includes, for each memory cell in the group, excluding from the group any neighbor memory cells that is adjacent to the memory cell and belongs to a same word line or bit line as the memory cell. In yet another embodiment, the memory cells in the array are assigned to hold n bits per cell, and storing the data includes programming the memory cells in the group with only *k* bits per cell, *k<n.*

In some embodiments, storing the data includes writing the data using programming commands that store a given data page in all the memory cells of a respective word line. In alternative embodiments, storing the data includes writing the data using programming commands that store a given data page either in odd-order or even-order memory cells of a respective word line.

In some embodiments, storing the data includes storing sensitive information in the group of the memory cells. In an embodiment, the sensitive information includes management information and/or power-down information. In a disclosed embodiment, storing the data includes applying to the data an additional protection mechanism that is not applied to other data stored outside the group. Applying the additional protection mechanism may include storing the data at a lower storage density relative to the other data; encoding the data with a stronger Error Correction Code (ECC) relative to the other data; and/or programming the memory cells in the group using a sequence of programming pulses that increase by an increment that is smaller relative to increments used outside the group.

There is additionally provided, in accordance with an embodiment of the present invention, a data storage apparatus including an interface and storage circuitry. The interface is configured to communicate with a memory including an array of analog memory cells. The storage circuitry is configured to select a group of the memory cells such that each memory cell in the group has one or more neighbor memory cells in the array that are excluded from the group, and to store data in the group of the memory cells while excluding the neighbor memory cells from programming as long as the data is stored in the group of the memory cells.

There is also provided, in accordance with an embodiment of the present invention, a data storage apparatus including a memory and storage circuitry. The memory includes an array of analog memory cells. The storage circuitry is configured to select a group of the memory cells such that each memory cell in the group has one or more neighbor memory cells in the array that are excluded from the group, and to store data in the group of the memory cells while excluding the neighbor memory cells from programming as long as the data is stored in the group of the memory cells.

The present invention will be more fully understood from the following detailed description of the embodiments thereof, taken together with the drawings in which:

### BRIEF DESCRIPTION OF THE DRAWINGS

Fig. 1 is a block diagram that schematically illustrates a memory system, in accordance with an embodiment of the present invention; and
Fig. 2 is a flow chart that schematically illustrates a method for data storage, in accordance with an embodiment of the present invention.

### DETAILED DESCRIPTION OF EMBODIMENTS

### OVERVIEW

Data is typically stored in analog memory cells by programming the memory cells to certain analog values, such as electrical charge levels or voltages. The data is retrieved from the memory cells by sensing the analog values. In some cases, memory cells may inflict cross-coupling interference on one another. This interference may distort the analog values read from the memory cells and cause read errors.

Embodiments of the present invention that are described herein provide improved methods and systems for storing data in analog memory cells. The disclosed techniques store data by programming a group of memory cells sparsely, such that each memory cell has one or more neighbor cells that remain un-programmed with data. This sort of programming helps to reduce cross-coupling interference, since the level of interference in a memory cell typically grows with the magnitudes of the analog values of its neighbors.

Several examples of sparse storage schemes are described hereinbelow. The disclosed schemes are simple to implement and do not incur considerable computational load, for example in comparison with schemes that cancel cross-coupling interference at readout time. The sparse storage schemes described herein differ from one another in the number of un-programmed neighbors per memory cell, and thus provide different trade-offs between data reliability and storage density.

The methods and systems described herein can be used both in memory devices that store different pages in different subsets of the memory cells in a word line (e.g., different pages in odd-order and even-order cells) and in All Bit Line (ABL) memory devices that store a page in all memory cells of a word line. The disclosed techniques are particularly suitable for storing sensitive information, such as management information, whose corruption would affect large amounts of stored data.

### SYSTEM DESCRIPTION

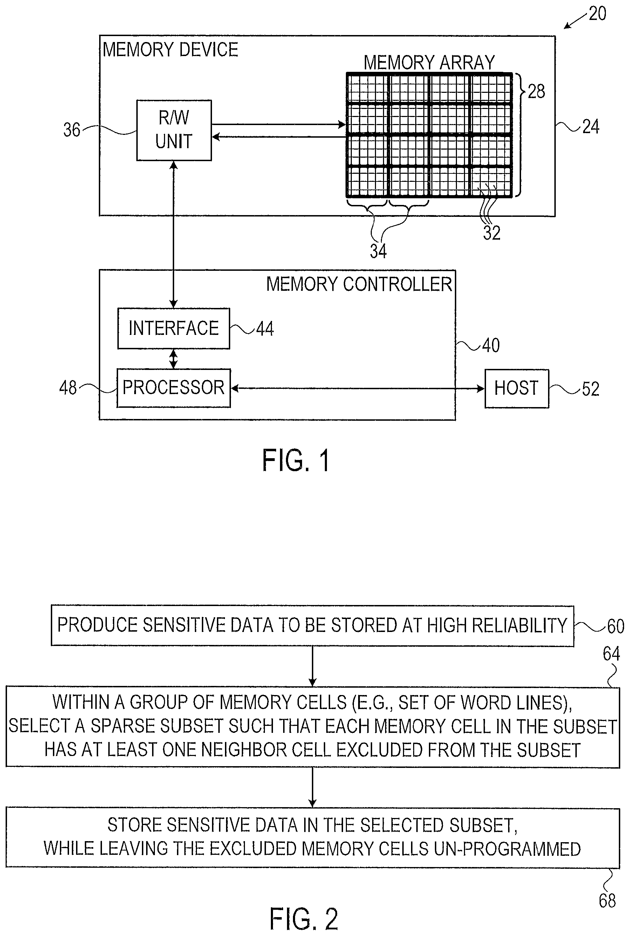

Fig. 1 is a block diagram that schematically illustrates a memory system 20, in accordance with an embodiment of the present invention. System 20 can be used in various host systems and devices, such as in computing devices, cellular phones or other communication terminals, removable memory modules (sometimes referred to as "USB Flash Drives"), Solid State Disks (SSD), digital cameras, music and other media players and/or any other system or device in which data is stored and retrieved.

System 20 comprises a memory device 24, which stores data in a memory cell array 28. The memory array comprises multiple memory blocks 34. Each memory block 34 comprises multiple analog memory cells 32. In the context of the present patent application and in the claims, the term "analog memory cell" is used to describe any memory cell that holds a continuous, analog value of a physical parameter, such as an electrical voltage or charge. Array 28 may comprise analog memory cells of any kind, such as, for example, NAND, NOR and Charge Trap Flash (CTF) Flash cells, phase change RAM (PRAM, also referred to as Phase Change Memory - PCM), Nitride Read Only Memory (NROM), Ferroelectric RAM (FRAM), magnetic RAM (MRAM) and/or Dynamic RAM (DRAM) cells.

The charge levels stored in the cells and/or the analog voltages or currents written into and read out of the cells are referred to herein collectively as analog values, analog storage values or storage values. The storage values may comprise, for example, threshold voltages or any other suitable kind of storage values. System 20 stores data in the analog memory cells by programming the cells to assume respective programming states, which are also referred to as programming levels. The programming states are selected from a finite set of possible states, and each programming state corresponds to a certain nominal storage value. For example, a 3 bit/cell MLC can be programmed to assume one of eight possible programming states by writing one of eight possible nominal storage values into the cell.

Memory device 24 comprises a reading/writing (R/W) unit 36, which converts data for storage in the memory device to analog storage values and writes them into memory cells 32. In alternative embodiments, the R/W unit does not perform the conversion, but is provided with voltage samples, i.e., with the storage values for storage in the cells. When reading data out of array 28, R/W unit 36 converts the storage values of memory cells 32 into digital samples having a resolution of one or more bits. Data is typically written to and read from the memory cells in groups that are referred to as pages. In some embodiments, the R/W unit can erase a group of cells 32 by applying one or more negative erasure pulses to the cells. Erasure is typically performed in entire memory blocks.

The storage and retrieval of data in and out of memory device 24 is performed by a memory controller 40. The memory controller comprises an interface 44 for communicating with memory device 24, and a processor 48 that carries out the various memory management functions. In particular, processor 48 carries stores at least some of the data using sparse, high-reliability storage schemes that are described in detail below.

Memory controller 40 communicates with a host 52, for accepting data for storage in the memory device and for outputting data retrieved from the memory device. Memory controller 40, and in particular processor 48, may be implemented in hardware. Alternatively, the memory controller may comprise a microprocessor that runs suitable software, or a combination of hardware and software elements.

The configuration of Fig. 1 is an exemplary system configuration, which is shown purely for the sake of conceptual clarity. Any other suitable memory system configuration can also be used. Elements that are not necessary for understanding the principles of the present invention, such as various interfaces, addressing circuits, timing and sequencing circuits and debugging circuits, have been omitted from the figure for clarity.

Although the example of Fig. 1 shows a single memory device 24, system 20 may comprise multiple memory devices that are controlled by memory controller 40. In the exemplary system configuration shown in Fig. 1, memory device 24 and memory controller 40 are implemented as two separate Integrated Circuits (ICs). In alternative embodiments, however, the memory device and the memory controller may be integrated on separate semiconductor dies in a single Multi-Chip Package (MCP) or System on Chip (SoC), and may be interconnected by an internal bus. Further alternatively, some or all of the memory controller circuitry may reside on the same die on which the memory array is disposed. Further alternatively, some or all of the functionality of memory controller 40 can be implemented in software and carried out by a processor or other element of the host system. In some embodiments, host 44 and memory controller 40 may be fabricated on the same die, or on separate dies in the same device package.

In some embodiments, memory controller 40 comprises a general-purpose processor, which is programmed in software to carry out the functions described herein. The software may be downloaded to the processor in electronic form, over a network, for example, or it may, alternatively or additionally, be provided and/or stored on non-transitory tangible media, such as magnetic, optical, or electronic memory.

In an example configuration of array 28, memory cells 32 are arranged in multiple rows and columns, and each memory cell comprises a floating-gate transistor. The gates of the transistors in each row are connected by word lines, and the sources of the transistors in each column are connected by bit lines. The memory array is typically divided into multiple pages, i.e., groups of memory cells that are programmed and read simultaneously. Pages are sometimes sub-divided into sectors. In some embodiments, each page comprises an entire row of the array. In alternative embodiments, each row (word line) can be divided into two or more pages. For example, in some devices each row is divided into two pages, one comprising the odd-order cells and the other comprising the even-order cells.

Typically, memory controller 40 programs data in page units, but erases entire memory blocks 34. Typically although not necessarily, a memory block is on the order of 10⁶ memory cells, whereas a page is on the order of 10³-10⁴ memory cells.

### HIGH-RELIABILITY STORAGE USING SPARSE PROGRAMMING

A given memory cell 32 in memory array 28 may be subject to cross-coupling interference from neighboring memory cells in the array. In the present context, the term "neighboring memory cell" is used broadly and refers to any memory cell that potentially inflicts cross-coupling interference on the memory cell in question. Neighboring memory cells may be immediately adjacent to the interfered memory cell (e.g., vertical neighbors on the same bit line, horizontal neighbors on the same word line or diagonal neighbors), or non-adjacent memory cells that nevertheless potentially cause interference.

Typically, the level of interference caused by a certain neighboring cell grows with the magnitude of the interfering cell's analog value. Therefore, a neighboring cell that is programmed with data (and particularly a neighboring cell programmed with data that corresponds to a high analog value) will typically cause stronger interference than an un-programmed memory cell. Un-programmed memory cells usually cause little or no interference, because they are set to an erased state represented by a relatively small negative analog value.

In some embodiments that are described herein, processor 48 stores certain data using a storage scheme that retains, for each programmed memory cell, one or more neighboring memory cells un-programmed with data. In other words, processor 48 stores the data such that each memory cell being programmed with data has one or more neighbor cells that remain un-programmed as long as the data is stored is held in the programmed cells. Such storage schemes are referred to herein as sparse storage schemes. In the description that follows, the sparse storage scheme is defined and applied by processor 48 in the memory controller. In alternative embodiments, however, the storage scheme may be applied by R/W unit 36 in the memory device. Thus, processor 48 and/or unit 36 are referred to herein collectively as storage circuitry that carries out the disclosed storage techniques.

In some embodiments, processor 48 applies the sparse storage scheme to a selected group of memory cells, e.g., a set of word lines or a memory block. Within this group of memory cells, processor 48 selects a partial subset of memory cells for programming, such that each memory cell in the subset has at least one neighboring cell that is excluded from the subset. Processor 48 stores data in the group by programming the memory cells in the partial subset while retaining the excluded memory cells un-programmed with data. As a result of the sparse programming, each programmed memory cell suffers relatively low cross-coupling interference, and the readout error probability is therefore reduced.

In various embodiments, processor 48 may use various kinds of sparse programming schemes. In the examples given below, memory cells 32 comprise four-level memory cells, each storing two bits of data. In each memory cell, one bit is referred to as Least Significant Bit (LSB) and one bit is referred to as Most Significant Bit (MSB). The memory cells along each word line are divided into even-order and odd-order cells (i.e., the memory cells belonging to the even- and odd-order bit lines, respectively). The memory controller stores two memory pages (referred to as LSB and MSB pages) in the even-order cells, and two additional pages memory pages (LSB and MSB) in the odd-order cells. This configuration, however, is chosen purely by way of example. In alternative embodiments, any other suitable memory configuration can be used.

In one embodiment, processor 48 applies a sparse storage scheme that is defined in the following table:

| Word line | Bit lines | Even-order bit lines | Odd-order bit lines |
|---|---|---|---|
| 0 | LSB page | 0 | |
| | MSB page | 1 | |
| 1 | LSB page | | |
| | MSB page | | |
| 2 | LSB page | 2 | |
| | MSB page | 3 | |
| 3 | LSB page | | |
| | MSB page | | |
| ... | | ... | ... |

In this scheme, a page is first written to the LSB page of the even-order bit lines on word line 0, then to the MSB page of the even-order bit lines on word line 0, then to the LSB page of the even-order bit lines on word line 2, then to the MSB page of the even-order bit lines on word line 2, and so on. Odd-order word lines and odd-order bit lines are not programmed at all.

As can be seen in the table, the programmed memory cells (on the intersections of the even-order word lines and even-order bit lines) have no immediate neighbors (i.e., cells that are directly adjacent to the memory cell, either diagonally, vertically or horizontally) that are programmed with data. Therefore, the memory cells experience little or no cross-coupling interference. On the other hand, this scheme stores data at only 25% of the capacity of the memory - since only a quarter of the memory cells are actually programmed.

In another embodiment, processor 48 applies a sparse storage scheme that is defined in the following table:

| Word line | Bit lines | Even-order bit lines | Odd-order bit lines |
|---|---|---|---|
| 0 | LSB page | 0 | |
| | MSB page | | |
| 1 | LSB page | | |
| | MSB page | | |
| 2 | LSB page | 1 | |
| | MSB page | | |
| 3 | LSB page | | |
| | MSB page | | |
| ... | | ... | ... |

In this scheme, data is programmed only to the LSB pages of the even-order bit lines on the even-order word lines. As in the previous scheme, the programmed memory cells in the present scheme have no adjacent neighbors that are programmed with data. Therefore, the memory cells experience little or no cross-coupling interference. Moreover, the present scheme stores data at a reduced density of 1 bit/cell instead of 2 bits/cell (by storing only the LSB page and not the MSB page), and therefore is more resilient to read errors. The high resilience comes at the expense of reduced capacity - The present scheme utilizes 12.5% of the memory capacity.

In yet another embodiment, processor 48 applies a sparse storage scheme that is defined in the following table:

| Word line | Bit lines | Even-order bit lines | Odd-order bit lines |
|---|---|---|---|
| 0 | LSB page | 0 | 1 |
| | MSB page | 2 | 3 |
| 1 | LSB page | | |
| | MSB page | | |
| 2 | LSB page | 4 | 5 |
| | MSB page | 6 | 7 |
| 3 | LSB page | | |
| | MSB page | | |
| ... | | ... | ... |

In this scheme too, only the even-order word lines are programmed. Memory pages are written alternately to the even-order and odd-order bit lines until the word line is fully programmed, and then programming advances to the next word line. In the present example, word line 0 is first programmed with four pages: A page is written to the LSB page of the even-order bit lines, a second page is written to the LSB page of the odd-order bit lines, then a page is written to the MSB page of the even-order bit lines, and a fourth page is written to the MSB page of the odd-order bit lines. The process is repeated on word line 2 (skipping word line 1), and so on.

In this sparse storage scheme, memory cells may suffer from some horizontal cross-coupling interference, since the horizontal neighbors of each programmed memory cell are also programmed. Vertical and diagonal interference, however, are eliminated. This scheme uses 50% of the memory capacity.

In another alternative embodiment, processor 48 applies a sparse storage scheme that is defined in the following table:

| Word line | Bit lines | Even-order bit lines | Odd-order bit lines |
|---|---|---|---|
| 0 | LSB page | 0 | |
| | MSB page | 1 | |
| 1 | LSB page | | 2 |
| | MSB page | | 3 |
| 2 | LSB page | 4 | |
| | MSB page | 5 | |
| 3 | LSB page | | 6 |
| | MSB page | | 7 |
| ... | | ... | ... |

In this scheme, processor 48 programs the even-order bit lines on the even-order word lines, and the odd-order bit lines on the odd-order word lines. Both LSB and MSB pages are programmed. In this sparse storage scheme, the vertical and horizontal neighboring cells are not programmed, but the diagonal neighbors are programmed. This scheme uses 50% of the memory capacity. (In an alternative but equivalent embodiment, processor 48 may program the even-order bit lines on the odd-order word lines, and the odd-order bit lines on the even-order word lines.)

In still another embodiment, processor 48 applies a sparse storage scheme that is defined in the following table:

| Word line | Bit lines | Even-order bit lines | Odd-order bit lines |
|---|---|---|---|
| 0 | LSB page | 0 | |
| | MSB page | | |
| 1 | LSB page | | 1 |
| | MSB page | | |
| 2 | LSB page | 2 | |
| | MSB page | | |
| 3 | LSB page | | 3 |
| | MSB page | | |
| ... | | ... | ... |

This scheme is similar to the previous example, with the addition that only the LSB pages are programmed. This sparse storage scheme has improved resilience to interference, at the expense of using only 25% of the memory capacity. As in the previous scheme, in an alternative embodiment processor 48 may program the even-order bit lines on the odd-order word lines, and the odd-order bit lines on the even-order word lines.

The example sparse programming schemes described above are chosen purely for the sake of conceptual clarity. In alternative embodiments, any other suitable programming scheme, which retains at least one un-programmed neighboring cell for each programmed memory cell, can be used. For example, the above-described schemes are applied in a memory that supports separate page write commands for programming the even- and odd-order memory cells in a given word line.

In some embodiments, the disclosed techniques are used in memory devices that program all the memory cells of a given word line in the same command (sometimes referred to as All Bit Lines - ABL - devices), e.g., by programming every second memory cell. This technique helps to reduce horizontal cross-coupling interference, i.e., interference from horizontal neighbors on the same word line as the interfered cell.

In some embodiments, processor 48 uses the sparse programming schemes described herein for increasing the storage reliability of sensitive information, as opposed to non-sensitive information. In these embodiments, the use of sparse programming is restricted to sensitive information because these techniques usually come at the expense of memory capacity. As such, the disclosed techniques may be used in specific areas of array 28, for example in specific sets of word lines in each block 34. In other areas of the memory, processor 48 may store the non-sensitive data while utilizing all the memory cells. Nevertheless, in alternative embodiments the disclosed techniques can be used for storing some or even all non-sensitive data, if desired.

The disclosed techniques enable processor 48 to store data with high reliability but with little or no Error Correction Code (ECC) redundancy. For example, the disclosed techniques, using an ECC rate on the order of 97%, can achieve the effective strength of an ECC having 25% rate and conventional programming schemes. This sort of configuration has performance benefits both during programming (less data is programmed, less resources and latency spent on ECC encoding) and during readout (less data is read, less resources and latency spent on ECC decoding).

Sensitive information may comprise any information whose loss or corruption would affect large amounts of stored data, or whose loss or corruption would cause additional damage or performance degradation beyond the loss of that specific information. Specific examples of sensitive information may comprise management data such as boot code (particularly if the boot time is restricted, so as to limit the boot code read time) or power-down data for which reliability should typically be high and program time is of importance. Non-sensitive information may comprise, for example, user data that is received from the host. Alternatively, processor 48 may use sparse programming for storing any other suitable type of information.

In some embodiments, processor 48 combines a sparse programming scheme with one or more additional protection mechanisms that increase storage reliability. Typically, the additional protection mechanism is not used other than for sparse storage. For example, processor 48 may store the data sparsely, and also using less than the number of bits per cell designated to memory cells 32. Consider, for example, a system in which processor 48 stores user data in memory cells 32 using *n* bits/cell, e.g., using 2*ⁿ* programming levels. In some embodiments, processor 48 may store sensitive information using sparse programming and also using only *k* bits/cell (2*^{k}* programming levels), *k<n.*

As another example, consider a system in which processor 48 encodes the user data with an ECC having a certain redundancy level (e.g., a certain code rate). In some embodiments, processor 48 may store sensitive information using sparse programming and also encode the sensitive information with an ECC having a higher redundancy level (e.g., lower code rate).

As yet another example, consider a system in which R/W unit 36 programs memory cells 32 in an iterative Programming and Verification (P&V) process. In such a process, the R/W unit applies to a group of memory cells a sequence of programming pulses that progressively increase in magnitude and/or duration. The analog values of the memory cells are verified during the programming sequence, and subsequent pulses are applied only to memory cells that have not yet reached their intended analog values.

In some embodiments, processor 48 may store user data by programming the memory cells using a pulse sequence that increases from pulse to pulse by a certain magnitude and/or duration increment, and store sensitive information by programming the memory cells using a pulse sequence that increases from pulse to pulse by a smaller increment. The smaller increment typically increases the storage accuracy, at the expense of programming speed.

In some embodiments, processor 48 may apply any suitable combination of the above-described protection mechanisms, or any other suitable protection mechanism for increasing storage reliability along with sparse programming.

Fig. 2 is a flow chart that schematically illustrates a method for data storage, in accordance with an embodiment of the present invention. The method begins with processor 48 of memory controller 40 producing sensitive information that is to be stored in memory device 24, at an information generation step 60.

Processor 48 selects a sparse subset of memory cells for storing the sensitive information, at a selection step 64. In an embodiment, processor 48 assigns a certain group of memory cells, e.g., a set of word lines, for storing the sensitive information. Within this group, processor 48 selects a partial subset of the memory cells that will actually be programmed. The other memory cells in the group will be excluded from programming as long as the sensitive information is stored in the partial subset.

The partial subset is selected such that each cell in the subset (which will be programmed) has at least one neighbor cell in the group that will be excluded from programming. Processor 48 may select the partial subset according to any suitable sparse programming scheme, such as the example schemes described above. Processor 48 stores the sensitive information in the selected subset of the memory cells, at a sparse programming step 68.

Although the embodiments described herein mainly address devices of analog memory cells such as Flash memory, the methods and systems described herein can also be used in other applications, such as in three-dimensional memory devices.

It will thus be appreciated that the embodiments described above are cited by way of example, and that the present invention is not limited to what has been particularly shown and described hereinabove. Rather, the scope of the present invention includes both combinations and sub-combinations of the various features described hereinabove, as well as variations and modifications thereof which would occur to persons skilled in the art upon reading the foregoing description and which are not disclosed in the prior art.

## Claims

1. A method for data storage, comprising:
in a memory (20) comprising an array (28) of analog memory cells (32), selecting (64), for storing first data, a group of the memory cells (32) such that each memory cell (32) in the group has one or more neighbor memory cells (32) in the array (28) that are excluded from the group;
storing (68) the first data in the group of the memory cells (32) using a sequence of programming pulses that increase by a first increment, while excluding the neighbor memory cells (32) from programming as long as the first data is stored in the group of the memory cells (32);
selecting another group of the memory cells (32) for storing second data; and
storing the second data in the another group of the memory cells (32) by programming the memory cells (32) in the another group using a sequence of programming pulses that increase by a second increment, greater than the first increment, while including in the programming all neighboring cells (32) in the another group.

2. The method according to claim 1, wherein selecting the group comprises excluding from the group all the immediate neighbor memory cells (32) of each memory cell (32) in the group.

3. The method according to claim 1, wherein selecting (64) the group comprises, for at least a part of the array, excluding from the group all the memory cells (32) belonging to odd-order word lines or all the memory cells (32) belonging to even-order word lines.

4. The method according to claim 1, wherein selecting (64) the group comprises, for at least a part of the array (28), excluding from the group all the memory cells (32) belonging to odd-order bit lines or all the memory cells (32) belonging to even-order bit lines.

5. The method according to claim 1, wherein selecting (64) the group comprises, for each memory cell (32) in the group, excluding from the group any neighbor memory cells (32) that is adjacent to the memory cell (32) and belongs to a same word line or bit line as the memory cell (32).

6. The method according to any of claims 1-5, wherein the memory cells (32) in the array (28) are assigned to hold *n* bits per cell, and wherein storing (68) the first data comprises programming the memory cells (32) in the group with only *k* bits per cell, *k*<*n*.

7. The method according to any of claims 1-5, wherein storing (68) the first data comprises writing the first data using programming commands that store a given data page in all the memory cells (32) of a respective word line.

8. The method according to any of claims 1-5, wherein storing (68) the first data comprises writing the first data using programming commands that store a given data page either in odd-order or even-order memory cells (32) of a respective word line.

9. The method according to claim 1, wherein storing the first data comprises storing sensitive information in the group of the memory cells, and wherein the sensitive information comprises at least one information type selected from a group of types consisting of management information and power-down information.

10. The method according to any of claims 1-5, wherein storing (68) the first data comprises applying to the first data an additional protection mechanism that is not applied to other data stored outside the group.

11. The method according to claim 10, wherein applying the additional protection mechanism comprises performing at least one action selected from a group of actions consisting of:
storing the first data at a lower storage density relative to the other data;
encoding the first data with a stronger Error Correction Code, ECC, relative to the other data; and
programming the memory cells in the group using a sequence of programming pulses that increase by an increment that is smaller relative to increments used outside the group.

12. A data storage apparatus (20), comprising:
an interface (44), which is configured to communicate with a memory (24) comprising an array (28) of analog memory cells (32); and
storage circuitry (36, 48), which is configured to:
select (64), for storing first data, a group of the memory cells (32) such that each memory cell (32) in the group has one or more neighbor memory cells (32) in the array (28) that are excluded from the group;
store (68) the first data in the group of the memory cells (32) using a sequence of programming pulses that increase by a first increment, while excluding the neighbor memory cells (32) from programming as long as the first data is stored in the group of the memory cells (32);
select another group of the memory cells (32) for storing second data; and
store the second data in the another group of the memory cells (32) using a sequence of programming pulses that increase by a second increment, greater than the first increment, while including in the programming all neighboring cells (32) in the another group.

13. The apparatus (20) according to claim 12, wherein the storage circuitry (36, 48) is configured to exclude from the group all the immediate neighbor memory cells (32) of each memory cell (32) in the group.

14. The apparatus (20) according to claim 12, wherein, for at least a part of the array (28), the storage circuitry (36, 48) is configured to exclude from the group all the memory cells (32) belonging to odd-order word lines or all the memory cells (32) belonging to even-order word lines.

15. The apparatus (20) according to claim 12, wherein, for at least a part of the array (28), the storage circuitry (36, 48) is configured to exclude from the group all the memory cells (32) belonging to odd-order bit lines or all the memory cells (32) belonging to even-order bit lines.

16. The apparatus (20) according to claim 12, wherein the storage circuitry (36, 48) is configured to exclude from the group, for each memory cell (32) in the group, any neighbor memory cells (32) that are adjacent to the memory cell (32) and belongs to a same word line or bit line as the memory cell (32).

17. The apparatus (20) according to any of claims 12-16, wherein the memory cells (32) in the array (28) are assigned to hold n bits per cell, and wherein the storage circuitry (36, 48) is configured to store (68) the first data by programming the memory cells (32) in the group with only k bits per cell, k<n.

18. The apparatus (20) according to any of claims 12-16, wherein the storage circuitry (36, 48) is configured to store (68) the first data using programming commands that store a given data page in all the memory cells (32) of a respective word line.

19. The apparatus (20) according to any of claims 12-16, wherein the storage circuitry (36, 48) is configured to store (68) the first data using programming commands that store a given data page either in odd-order or even-order memory cells (32) of a respective word line.

20. The apparatus (20) according to claim 12, wherein the storage circuitry is configured to store sensitive information in the group of the memory cells while excluding the neighbor memory cells, and wherein the sensitive information comprises at least one information type selected from a group of types consisting of management information and power-down information.

21. The apparatus (20) according to any of claims 12-16, wherein the storage circuitry (36, 48) is configured to apply to the first data an additional protection mechanism that is not applied to other data stored outside the group.

22. The apparatus (20) according to claim 21, wherein the storage circuitry (36, 48) is configured to apply the additional protection mechanism by performing at least one action selected from a group of actions consisting of:
storing the first data at a lower storage density relative to the other data;
encoding the first data with a stronger Error Correction Code, ECC, relative to the other data; and
programming the memory cells in the group using a sequence of programming pulses that increase by an increment that is smaller relative to increments used outside the group.

## Patentansprüche

1. Verfahren zur Datenspeicherung, umfassend:
in einem Speicher (20), der ein Array (28) von analogen Speicherzellen (32) umfasst, Auswählen (64) einer Gruppe der Speicherzellen (32) zum Speichern erster Daten, so dass jede Speicherzelle (32) in der Gruppe eine oder mehrere Nachbarspeicherzellen (32) in dem Array (28) hat, die von der Gruppe ausgeschlossen sind;
Speichern (68) der ersten Daten in der Gruppe der Speicherzellen (32) unter Verwendung einer Folge von Programmierimpulsen, die um ein erstes Inkrement ansteigen, während die benachbarten Speicherzellen (32) von der Programmierung ausgeschlossen werden, solange die ersten Daten in der Gruppe der Speicherzellen (32) gespeichert sind;
Auswählen einer anderen Gruppe der Speicherzellen (32) zum Speichern zweiter Daten; und
Speichern der zweiten Daten in der anderen Gruppe der Speicherzellen (32) durch Programmieren der Speicherzellen (32) in der anderen Gruppe unter Verwendung einer Sequenz von Programmierimpulsen, die um ein zweites Inkrement ansteigen, das größer als das erste Inkrement ist, während alle benachbarten Zellen (32) in der anderen Gruppe in die Programmierung einbezogen werden.

2. Verfahren nach Anspruch 1, wobei das Auswählen der Gruppe ein Ausschließen aller unmittelbar benachbarten Speicherzellen (32) jeder Speicherzelle (32) in der Gruppe aus der Gruppe umfasst.

3. Verfahren nach Anspruch 1, wobei das Auswählen (64) der Gruppe für mindestens einen Teil des Arrays ein Ausschließen aller Speicherzellen (32), die zu Wortleitungen ungerader Ordnung gehören, oder aller Speicherzellen (32), die zu Wortleitungen gerader Ordnung gehören, aus der Gruppe umfasst.

4. Verfahren nach Anspruch 1, wobei das Auswählen (64) der Gruppe für mindestens einen Teil des Arrays (28) ein Ausschließen aller Speicherzellen (32), die zu Bitleitungen ungerader Ordnung gehören, oder aller Speicherzellen (32), die zu Bitleitungen gerader Ordnung gehören, aus der Gruppe umfasst.

5. Verfahren nach Anspruch 1, wobei das Auswählen (64) der Gruppe für jede Speicherzelle (32) in der Gruppe ein Ausschließen aller benachbarten Speicherzellen (32) aus der Gruppe umfasst, die zu der Speicherzelle (32) benachbart sind und zu einer selben Wortleitung oder Bitleitung wie die Speicherzelle (32) gehören.

6. Verfahren nach einem der Ansprüche 1 bis 5, wobei die Speicherzellen (32) in dem Array (28) so zugeordnet sind, dass sie *n* Bits pro Zelle halten, und wobei das Speichern (68) der ersten Daten ein Programmieren der Speicherzellen (32) in der Gruppe mit nur *k* Bits pro Zelle umfasst, wobei *k<* n.

7. Verfahren nach einem der Ansprüche 1-5, wobei das Speichern (68) der ersten Daten ein Schreiben der ersten Daten unter Verwendung von Programmieranweisungen umfasst, die eine gegebene Datenseite in allen Speicherzellen (32) einer jeweiligen Wortleitung speichern.

8. Verfahren nach einem der Ansprüche 1-5, wobei das Speichern (68) der ersten Daten ein Schreiben der ersten Daten unter Verwendung von Programmieranweisungen umfasst, die eine gegebene Datenseite entweder in Speicherzellen (32) ungerader oder gerader Ordnung einer jeweiligen Wortleitung speichern.

9. Verfahren nach Anspruch 1, wobei das Speichern der ersten Daten ein Speichern sensibler Informationen in der Gruppe der Speicherzellen umfasst, und wobei die sensiblen Informationen mindestens einen Informationstyp umfassen, der aus einer Gruppe von Typen ausgewählt ist, die aus Verwaltungsinformationen und Abschaltinformationen besteht.

10. Verfahren nach einem der Ansprüche 1 bis 5, wobei das Speichern (68) der ersten Daten ein Anwenden eines zusätzlichen Schutzmechanismus auf die ersten Daten umfasst, der auf andere Daten, die außerhalb der Gruppe gespeichert sind, nicht angewendet wird.

11. Verfahren nach Anspruch 10, wobei das Anwenden des zusätzlichen Schutzmechanismus ein Durchführen mindestens einer Aktion umfasst, die aus einer Gruppe von Aktionen ausgewählt ist, die aus folgenden Aktionen besteht:
Speichern der ersten Daten mit einer geringeren Speicherdichte relativ zu den anderen Daten;
Codieren der ersten Daten mit einem stärkeren Fehlerkorrekturcode, ECC, relativ zu den anderen Daten; und
Programmieren der Speicherzellen in der Gruppe mit einer Folge von Programmierimpulsen, die um ein Inkrement ansteigen, das relativ zu außerhalb der Gruppe verwendeten Inkrementen kleiner ist.

12. Datenspeichervorrichtung (20), umfassend:
eine Schnittstelle (44), die so konfiguriert ist, dass sie mit einem Speicher (24) kommuniziert, der ein Array (28) von analogen Speicherzellen (32) umfasst; und
eine Speicherschaltung (36, 48), konfiguriert zum:
Auswählen (64) einer Gruppe der Speicherzellen (32) zum Speichern erster Daten, so dass jede Speicherzelle (32) in der Gruppe eine oder mehrere benachbarte Speicherzellen (32) in dem Array (28) hat, die von der Gruppe ausgeschlossen sind;
Speichern (68) der ersten Daten in der Gruppe der Speicherzellen (32) unter Verwendung einer Folge von Programmierimpulsen, die um ein erstes Inkrement ansteigen, während die benachbarten Speicherzellen (32) von der Programmierung ausgeschlossen werden, solange die ersten Daten in der Gruppe der Speicherzellen (32) gespeichert sind;
Auswählen einer anderen Gruppe der Speicherzellen (32) zum Speichern zweiter Daten; und
Speichern der zweiten Daten in der anderen Gruppe der Speicherzellen (32) unter Verwendung einer Folge von Programmierimpulsen, die um ein zweites Inkrement ansteigen, das größer ist als das erste Inkrement, während alle benachbarten Zellen (32) in der anderen Gruppe in die Programmierung einbezogen werden.

13. Vorrichtung (20) nach Anspruch 12, wobei die Speicherschaltung (36, 48) so konfiguriert ist, dass sie alle unmittelbar benachbarten Speicherzellen (32) jeder Speicherzelle (32) in der Gruppe aus der Gruppe ausschließt.

14. Vorrichtung (20) nach Anspruch 12, wobei für mindestens einen Teil des Arrays (28) die Speicherschaltung (36, 48) so konfiguriert ist, dass sie alle Speicherzellen (32), die zu Wortleitungen ungerader Ordnung gehören, oder alle Speicherzellen (32), die zu Wortleitungen gerader Ordnung gehören, aus der Gruppe ausschließt.

15. Vorrichtung (20) nach Anspruch 12, wobei für mindestens einen Teil des Arrays (28) die Speicherschaltung (36, 48) so konfiguriert ist, dass sie alle Speicherzellen (32), die zu Bitleitungen ungerader Ordnung gehören, oder alle Speicherzellen (32), die zu Bitleitungen gerader Ordnung gehören, aus der Gruppe ausschließt.

16. Vorrichtung (20) nach Anspruch 12, wobei die Speicherschaltung (36, 48) so konfiguriert ist, dass sie für jede Speicherzelle (32) in der Gruppe alle benachbarten Speicherzellen (32) von der Gruppe ausschließt, die der Speicherzelle (32) benachbart sind und zu einer selben Wortleitung oder Bitleitung wie die Speicherzelle (32) gehören.

17. Vorrichtung (20) nach einem der Ansprüche 12-16, wobei die Speicherzellen (32) in dem Array (28) so zugeordnet sind, dass sie *n* Bits pro Zelle halten, und wobei die Speicherschaltung (36, 48) so konfiguriert ist, dass sie die ersten Daten speichert (68), indem sie die Speicherzellen (32) in der Gruppe mit nur *k* Bits pro Zelle programmiert, wobei *k*< n.

18. Vorrichtung (20) nach einem der Ansprüche 12-16, wobei die Speicherschaltung (36, 48) so konfiguriert ist, dass sie die ersten Daten unter Verwendung von Programmieranweisungen speichert (68), die eine gegebene Datenseite in allen Speicherzellen (32) einer jeweiligen Wortleitung speichern.

19. Vorrichtung (20) nach einem der Ansprüche 12-16, wobei die Speicherschaltung (36, 48) so konfiguriert ist, dass sie die ersten Daten unter Verwendung von Programmieranweisungen speichert (68), die eine gegebene Datenseite entweder in Speicherzellen (32) ungerader oder gerader Ordnung einer jeweiligen Wortleitung speichern.

20. Vorrichtung (20) nach Anspruch 12, wobei die Speicherschaltung so konfiguriert ist, dass sie sensible Informationen in der Gruppe der Speicherzellen speichert, während sie die benachbarten Speicherzellen ausschließt, und wobei die sensiblen Informationen mindestens einen Informationstyp umfassen, der aus einer Gruppe von Typen ausgewählt ist, die aus Verwaltungsinformationen und Abschaltinformationen besteht.

21. Vorrichtung (20) nach einem der Ansprüche 12-16, wobei die Speicherschaltung (36, 48) so konfiguriert ist, dass sie auf die ersten Daten einen zusätzlichen Schutzmechanismus anwendet, der auf andere Daten, die außerhalb der Gruppe gespeichert sind, nicht angewendet wird.

22. Vorrichtung (20) nach Anspruch 21, wobei die Speicherschaltung (36, 48) so konfiguriert ist, dass sie den zusätzlichen Schutzmechanismus anwendet, indem sie mindestens eine Aktion ausführt, die aus einer Gruppe von Aktionen ausgewählt ist, die aus folgenden Aktionen besteht:
Speichern der ersten Daten mit einer geringeren Speicherdichte relativ zu den anderen Daten;
Codieren der ersten Daten mit einem stärkeren Fehlerkorrekturcode, ECC, relativ zu den anderen Daten; und
Programmieren der Speicherzellen in der Gruppe mit einer Folge von Programmierimpulsen, die um ein Inkrement ansteigen, das relativ zu den außerhalb der Gruppe verwendeten Inkrementen kleiner ist.

## Revendications

1. Un procédé de stockage de données, comprenant :
dans une mémoire (20) comprenant un réseau (28) de cellules de mémoire analogiques (32), la sélection (64), pour le stockage de premières données, d'un groupe des cellules de mémoire (32) de telle sorte que chaque cellule de mémoire (32) du groupe ait une ou plusieurs cellules de mémoire voisines (32) du réseau (28) qui soient exclues du groupe ;
le stockage (68) des premières données dans le groupe des cellules de mémoire (32) à l'aide d'une séquence d'impulsions de programmation qui augmentent d'un premier incrément, en excluant de la programmation les cellules de mémoire voisines (32) tant que les premières données sont stockées dans le groupe des cellules de mémoire (32) ;
la sélection d'un autre groupe de cellules de mémoire (32) pour le stockage de secondes données ; et
le stockage des secondes données dans l'autre groupe des cellules de mémoire (32) par programmation des cellules de mémoire (32) de l'autre groupe à l'aide d'une séquence d'impulsions de programmation qui augmentent d'un second incrément, supérieur au premier incrément, en incluant dans la programmation toutes les cellules voisines (32) de l'autre groupe.

2. Le procédé selon la revendication 1, dans lequel la sélection du groupe comprend l'exclusion du groupe de toutes les cellules de mémoire immédiatement voisines (32) de chaque cellule de mémoire (32) du groupe.

3. Le procédé selon la revendication 1, dans lequel la sélection (64) du groupe comprend, pour au moins une partie du réseau, l'exclusion du groupe de toutes les cellules de mémoire (32) qui appartiennent à des lignes de mot d'ordre impair ou de toutes les cellules de mémoire (32) qui appartiennent à des lignes de mot d'ordre pair.

4. Le procédé selon la revendication 1, dans lequel la sélection (64) du groupe comprend, pour au moins une partie du réseau (28), l'exclusion du groupe de toutes les cellules de mémoire (32) qui appartiennent à des lignes de bit d'ordre impair ou de toutes les cellules de mémoire (32) qui appartiennent à des lignes de bit d'ordre pair.

5. Le procédé selon la revendication 1, dans lequel la sélection (64) du groupe comprend, pour chaque cellule de mémoire (32) du groupe, l'exclusion du groupe de toute cellule de mémoire voisine (32) qui est adjacente à la cellule de mémoire (32) et qui appartient à une même ligne de mot ou ligne de bit que la cellule mémoire (32).

6. Le procédé selon l'une des revendications 1 à 5, dans lequel les cellules de mémoire (32) du réseau (28) sont attribuées pour conserver *n* bits par cellule, et dans lequel le stockage (68) des premières données comprend la programmation des cellules de mémoire (32) du groupe sur seulement *k* bits par cellule, avec *k < n.*

7. Le procédé selon l'une des revendications 1 à 5, dans lequel le stockage (68) des premières données comprend l'inscription des premières données à l'aide de commandes de programmation qui stockent une page de données donnée dans toutes les cellules de mémoire (32) d'une ligne de mot respective.

8. Le procédé selon l'une des revendications 1 à 5, dans lequel le stockage (68) des premières données comprend l'inscription des premières données à l'aide de commandes de programmation qui stockent une page de données donnée dans des cellules de mémoire (32) soit d'ordre impair soit d'ordre pair d'une ligne de mot respective.

9. Le procédé selon la revendication 1, dans lequel le stockage des premières données comprend le stockage d'informations sensibles dans le groupe de cellules de mémoire, et dans lequel les informations sensibles comprennent au moins un type d'information choisi dans un groupe de types constitué par des informations de gestion et des informations de mise hors tension.

10. Le procédé selon l'une des revendications 1 à 5, dans lequel le stockage (68) des premières données comprend l'application aux premières données d'un mécanisme de protection supplémentaire qui n'est pas appliqué aux autres données stockées hors du groupe.

11. Le procédé selon la revendication 10, dans lequel l'application du mécanisme de protection supplémentaire comprend l'exécution d'au moins une action choisie dans un groupe d'actions constitué par :
le stockage des premières données à une densité de stockage moindre que pour les autres données ;
le codage des premières données avec un code de correction d'erreur, ECC, plus fort que pour les autres données ; et
la programmation des cellules mémoire du groupe à l'aide d'une séquence d'impulsions de programmation qui augmente d'un incrément qui est plus faible que les incréments utilisés hors du groupe.

12. Un appareil de stockage de données (20) comprenant :
une interface (44), qui est configurée pour communiquer avec une mémoire (24) comprenant un réseau (28) de cellules de mémoire analogiques (32) ; et
une circuiterie de stockage (36, 48), qui est configurée pour :
sélectionner (64), pour le stockage de premières données, un groupe des cellules de mémoire (32) de telle sorte que chaque cellule de mémoire (32) du groupe ait une ou plusieurs cellules de mémoire voisines (32) du réseau (28) qui soient exclues du groupe ;
stocker (68) des premières données dans le groupe des cellules de mémoire (32) à l'aide d'une séquence d'impulsions de programmation qui augmentent d'un premier incrément, en excluant de la programmation les cellules de mémoire voisines (32) tant que les premières données sont stockées dans le groupe des cellules de mémoire (32) ;
sélectionner un autre groupe de cellules de mémoire (32) pour le stockage de secondes données ; et
stocker des secondes données dans l'autre groupe des cellules de mémoire (32) à l'aide d'une séquence d'impulsions de programmation qui augmentent d'un second incrément, supérieur au premier incrément, en incluant dans la programmation toutes les cellules voisines (32) de l'autre groupe.

13. L'appareil (20) selon la revendication 12, dans lequel la circuiterie de stockage est configurée pour exclure du groupe toutes les cellules de mémoire immédiatement voisines (32) de chaque cellule de mémoire (32) du groupe.

14. L'appareil (20) selon la revendication 12, dans lequel, pour au moins une partie du réseau (28), la circuiterie de stockage (36, 48) est configurée pour exclure du groupe toutes les cellules de mémoire (32) qui appartiennent à des lignes de mot d'ordre impair ou toutes les cellules de mémoire (32) qui appartiennent à des lignes de mot d'ordre pair.

15. L'appareil (20) selon la revendication 12, dans lequel, pour au moins une partie du réseau (28), la circuiterie de stockage (36, 48) est configurée pour exclure du groupe toutes les cellules de mémoire (32) qui appartiennent à des lignes de bit d'ordre impair ou de toutes les cellules de mémoire (32) qui appartiennent à des lignes de bit d'ordre pair.

16. L'appareil (20) selon la revendication 12, dans lequel la circuiterie de stockage (36, 48) est configurée pour exclure du groupe, pour chaque cellule de mémoire (32) du groupe, toute cellule de mémoire voisine (32) qui est adjacente à la cellule de mémoire (32) et qui appartient à une même ligne de mot ou ligne de bit que la cellule mémoire (32).

17. L'appareil (20) selon l'une des revendications 12 à 16, dans lequel les cellules de mémoire (32) du réseau (28) sont attribuées pour conserver *n* bits par cellule, et dans lequel la circuiterie de stockage (36, 48) est configurée pour stocker (68) les premières données par programmation des cellules de mémoire (32) du groupe sur seulement *k* bits par cellule, avec *k* < *n.*

18. L'appareil (20) selon l'une des revendications 12 à 16, dans lequel la circuiterie de stockage (36, 48) est configurée pour stocker (68) les premières données à l'aide de commandes de programmation qui stockent une page de données donnée dans toutes les cellules de mémoire (32) d'une ligne de mot respective.

19. L'appareil (20) selon l'une des revendications 12 à 16, dans lequel la circuiterie de stockage (36, 48) est configurée pour stocker (68) les premières données à l'aide de commandes de programmation qui stockent une page de données donnée dans des cellules de mémoire (32) soit d'ordre impair soit d'ordre pair d'une ligne de mot respective.

20. L'appareil (20) selon la revendication 12, dans lequel la circuiterie de stockage (36, 48) est configurée pour stocker des informations sensibles dans le groupe de cellules de mémoire tout en excluant les cellules de mémoire voisine, et dans lequel les informations sensibles comprennent au moins un type d'information choisi dans un groupe de types constitué par des informations de gestion et des informations de mise hors tension.

21. L'appareil (20) selon l'une des revendications 12 à 16, dans lequel la circuiterie de stockage (36, 48) est configurée pour appliquer aux premières données un mécanisme de protection supplémentaire qui n'est pas appliqué aux autres données stockées hors du groupe.

22. L'appareil (20) selon la revendication 21, dans lequel la circuiterie de stockage (36, 48) est configurée pour appliquer le mécanisme de protection supplémentaire par exécution d'au moins une action choisie dans un groupe d'actions constitué par :
le stockage des premières données à une densité de stockage moindre que pour les autres données ;
le codage des premières données avec un code de correction d'erreur, ECC, plus fort que pour les autres données ; et
la programmation des cellules mémoire du groupe à l'aide d'une séquence d'impulsions de programmation qui augmente d'un incrément qui est plus faible que les incréments utilisés hors du groupe.
